# EUROPEAN PATENT SPECIFICATION

(11) **EP 4 513 202 B1**
(45) Date of publication and mention of the grant of the patent: **30.09.2026**
(21) Application number: 23919476.4
(22) Date of filing: 05.12.2023
(51) Int. Cl.: G01R 29/02, H01Q 1/00, G01D 18/00, G01D 21/02, H01Q 3/00, H04B 17/21, G01R 27/02, H01Q 1/22

(54) **IMPEDANCE CALIBRATION METHOD, ELECTRONIC DEVICE, MEDIUM AND PRODUCT**
IMPEDANZKALIBRIERVERFAHREN, ELEKTRONISCHE VORRICHTUNG, MEDIUM UND PRODUKT
PROCÉDÉ D'ÉTALONNAGE D'IMPÉDANCE, DISPOSITIF ÉLECTRONIQUE, SUPPORT ET PRODUIT

(30) Priority: 01.02.2023 CN 202310101346
(43) Date of publication of application: 26.02.2025
(73) Proprietor: Honor Device Co., Ltd., Shenzhen, Guangdong 518040 (CN)
(72) Inventor: LIU, Liang, Shenzhen, Guangdong 518040 (CN); CAI, Xiaotao, Shenzhen, Guangdong 518040 (CN); YE, Chunhui, Shenzhen, Guangdong 518040 (CN); ZHOU, Dawei, Shenzhen, Guangdong 518040 (CN); LIU, Shumin, Shenzhen, Guangdong 518040 (CN); XU, Yuan, Shenzhen, Guangdong 518040 (CN)
(74) Representative: Beder, Jens
(86) International application number: PCT/CN2023/136476
(87) International publication number: WO 2024/159912

(56) References cited:
- CN-A- 1 316 795
- CN-A- 1 883 122
- CN-A- 107 786 286
- CN-A- 113 992 792
- CN-A- 114 430 281
- CN-A- 114 937 867
- JP-A- 2009 218 967
- JP-A- 2013 229 837
- US-A1- 2014 206 297
- US-A1- 2018 342 794

## Description

### TECHNICAL FIELD

This application relates to the field of antenna communication technologies, and in particular, to an impedance calibration method, an electronic device, a medium, and a product.

### BACKGROUND

After delivery of a terminal device, impedance of an adapted antenna is determined. However, in actual implementation, when the terminal device performs wireless communication, real-time impedance of the antenna changes with proximity of an object within a specific range, resulting in reduced operating efficiency of the antenna.

The document US 2018/0342794 A1 shows an electronic device antenna having multi-band tuning capabilities.

### SUMMARY

The present invention is defined by the independent claims. Further advantageous developments are shown by the dependent claims.

This application provides an impedance calibration method, an electronic device, a medium, and a product, to resolve a problem of reduced operating efficiency of an antenna. To achieve the foregoing objective, the following technical solutions are used in this application.

According to the invention, this application provides an impedance calibration method. The method may be applied to an electronic device, and includes:
determining whether a state of a sensor satisfies a preset condition; obtaining an impedance point position of a current antenna, in a smith chart, when it is determined that the state of the sensor satisfies the preset condition; and using the impedance point position of the current antenna as a position of reference impedance when it is determined that an impedance position of the current antenna is in preset free space. According to this application, whether an antenna of the electronic device is in a free space scenario is determined by determining whether the state of the sensor satisfies the preset condition and determining whether the impedance position of the current antenna is in the preset free space. When it is determined that the antenna of the electronic device is in the free space scenario, the impedance point position of the current antenna may be used as the position of the reference impedance, so that the position of the reference impedance in the free space scenario may be updated to calibrate antenna impedance.

Further according to the invention: before the determining a state of a sensor in the electronic device, the method further comprises: determining, in a smith chart, positions of a plurality of preset frequency channel numbers of different operating frequencies and a free space radius corresponding to each preset frequency channel number; and determining, in the smith chart, based on a position of a preset frequency channel number of each operating frequency and a corresponding free space radius, free space of each preset frequency channel number at a corresponding operating frequency.. For example, a length of the free space radius is preset to be 10 mm. A circle is drawn using a position of a frequency channel number of an operating frequency of 1,980 MHz as a center and 10 mm as a radius, and the circle is free space corresponding to the frequency channel number at the operating frequency of 1,980 MHz.

In some possible implementations, after the impedance point position of the current antenna is used as the position of the reference impedance, a free space position of the impedance point of the current antenna may further be determined based on the impedance point position of the current antenna and the free space radius of the corresponding preset frequency channel number. For example, an example in which a current impedance point position in free space corresponding to a preset operating frequency of 1,950 MHz is used. The impedance point position of the antenna may be updated to a position of an operating frequency channel number of the current antenna at the operating frequency of 1,950 MHz, and the free space radius r may remain unchanged, to further determine an updated impedance point position and free space corresponding to an updated impedance point.

In some possible implementations, the impedance point position of the current antenna is obtained in response to the state of the sensor satisfying the preset condition. Next, whether the impedance point of the current antenna is a preset frequency channel number is first determined, and whether the impedance position of the current antenna is in free space corresponding to the preset frequency channel number is then determined. The impedance point position of the current antenna is used as the position of the reference impedance when it is determined that the impedance point of the current antenna is the preset frequency channel number and that the impedance position of the current antenna is in the free space corresponding to the preset frequency channel number.

In some possible implementations, whether the impedance point of the current antenna is a preset frequency channel number may be determined in the following manners: separately determining a distance between the impedance point of the current antenna and each preset frequency channel number; comparing each distance with a corresponding preset threshold distance; and determining, when it is determined that the distance is less than or equal to the corresponding preset threshold distance, that the impedance point of the current antenna is the corresponding preset frequency channel number.

In other words, a threshold distance between each frequency channel number and the operating frequency channel number of the current antenna may be preset. When it is determined that a distance between the operating frequency channel number of the current antenna and the frequency channel number is less than the corresponding threshold distance, it may be determined that the operating frequency channel number of the current antenna is the preset frequency channel number.

In some possible implementations, a frequency channel number closest to the operating frequency channel number of the current antenna may be first determined from the plurality of frequency channel numbers, and then a relationship between the corresponding preset threshold distance and the distance between the frequency channel number and the operating frequency channel number of the current antenna may be determined. When it is determined that the distance between the frequency channel number and the operating frequency channel number of the current antenna is less than or equal to the corresponding preset threshold distance, it may be determined that the operating frequency channel number of the current antenna is the preset frequency channel number. For example, when it is determined that the distance between the frequency channel number and the operating frequency channel number of the current antenna is 7 mm, and the corresponding preset threshold distance is 10 mm, it may be determined that the operating frequency channel number of the current antenna is the preset frequency channel number. When it is determined that the distance between the frequency channel number and the operating frequency channel number of the current antenna is 11 mm, it may be determined that the operating frequency channel number of the current antenna is not the preset frequency channel number.

In some possible implementations, whether the impedance position of the current antenna is in the free space corresponding to the preset frequency channel number may be determined in the following manners:
determining, when it is determined that the distance between the impedance point of the current antenna and the corresponding preset frequency channel number is less than or equal to the free space radius corresponding to the preset frequency channel number, that the impedance position of the current antenna is in the preset free space corresponding to the preset frequency channel number.

Specifically, whether the distance between the operating frequency channel number of the current antenna and the frequency channel number is less than or equal to a length of the corresponding free space radius may be determined. When it is determined that the distance between the operating frequency channel number of the current antenna and the frequency channel number is less than or equal to the length of the corresponding free space radius, it may be determined that the operating frequency channel number of the current antenna is in the free space. For example, when it is determined that the operating frequency channel number of the current antenna is a frequency channel number of an operating frequency of 1,950 MHz and determined that a distance between an operating frequency channel number B of the current antenna and the frequency channel number A of the preset operating frequency of 1,950 MHz is equal to the corresponding free space radius r, it may be determined that the operating frequency channel number of the current antenna, that is, the current impedance point position is in free space corresponding to the frequency channel number A of the operating frequency of 1,950 MHz.

In some possible implementations, the sensor may include at least one of a receiver, an ambient light sensor, a distance sensor, an acceleration sensor, an ultrasonic sensor, and an optical proximity sensor.

According to a second aspect, this application provides an electronic device including a processor and a memory.

The memory stores one or more computer programs, and the one or more computer programs include instructions. When the instructions are executed by the processor, the electronic device is enabled to perform the method according to any one of the first aspect.

According to a third aspect, this application provides a computer storage medium including computer instructions. When the computer instructions are run on a mobile terminal, an electronic device is enabled to perform the method according to any one of the first aspect.

According to a fourth aspect, this application provides a computer program product including instructions. When the instructions are run by an electronic device, the electronic device is enabled to perform the method according to any one of the first aspect.

It can be learned from the foregoing technical solution that this application has the following beneficial effects:

This application provides an impedance calibration method, an electronic device, a medium, and a product, and relates to the field of terminal device technologies. The method may be applied to the electronic device and includes: determining whether a state of a sensor satisfies a preset condition; obtaining an impedance point position of a current antenna when it is determined that the state of the sensor satisfies the preset condition; and using the impedance point position of the current antenna as a position of reference impedance when it is determined that an impedance position of the current antenna is in preset free space. According to this application, whether an antenna of the electronic device is in a free space scenario is determined by determining whether the state of the sensor satisfies the preset condition and determining whether the impedance position of the current antenna is in the preset free space. When it is determined that the antenna of the electronic device is in the free space scenario, the impedance point position of the current antenna may be used as the position of the reference impedance, so that the position of the reference impedance in the free space scenario may be updated to calibrate antenna impedance.

### BRIEF DESCRIPTION OF DRAWINGS

FIG. 1 is a schematic diagram of an environment in which a wireless communication device antenna is located according to an embodiment of this application;
FIG. 2 is a schematic diagram of a wireless communication device according to an embodiment of this application;
FIG. 3 is an internal architecture of a wireless communication electronic device according to an embodiment of this application;
FIG. 4 is a schematic diagram of a software structure of an electronic device according to an embodiment of this application;
FIG. 5 is a flowchart of an impedance calibration method according to an embodiment of this application;
FIG. 6 is a schematic diagram of free space of an antenna at different operating frequencies according to an embodiment of this application;
FIG. 7 is a schematic diagram of free space of another antenna according to an embodiment of this application; and
FIG. 8 is a schematic diagram of updated impedance information according to an embodiment of this application.

### DESCRIPTION OF EMBODIMENTS

In the specification, claims, and accompanying drawings of this application, the terms "first", "second", "third", and the like are intended to distinguish between different objects but do not indicate a particular order.

In embodiments of this application, the terms such as "example" or "for example" are used to represent giving an example, an illustration, or a description. Any embodiment or design scheme described as "example" or "for example" in embodiments of this application should not be explained as being more preferred or having more advantages than another embodiment or design scheme. Exactly, use of the terms such as "example" or "for example" is intended to present a relative concept in a specific manner.

To describe the following embodiments clearly and concisely, brief descriptions for conventional technologies are briefly described first:

An antenna of a terminal device is a device that is on the terminal device and that is configured to receive a signal. Using a mobile phone as an example, an old-type mobile phone has an outward protruding antenna, while an antenna of a new-type mobile phone is usually hidden in the phone body. This type of antenna is mainly inside the mobile phone, and an object inside cannot be seen from the outside of the mobile phone.

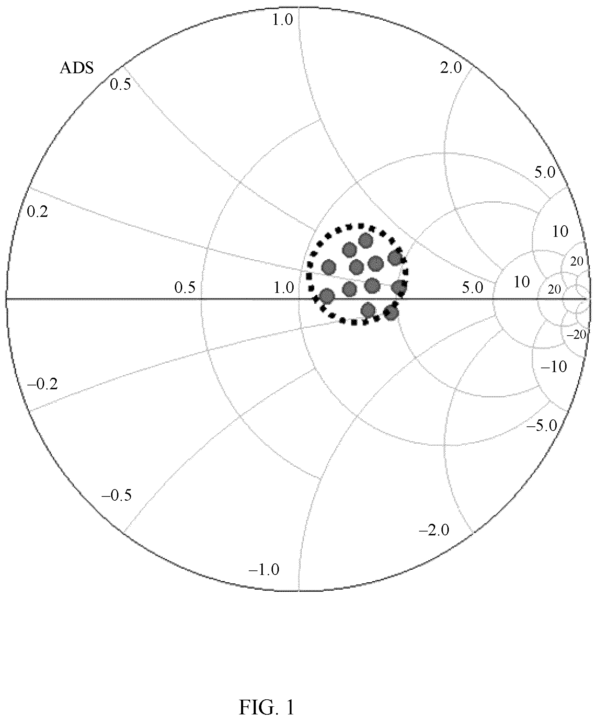

A mobile phone antenna is a standing wave antenna. An environment in which the antenna is located may include free space and non-free space. As shown in FIG. 1, an example in which there is one free space within the Smith circle and an operating frequency is 1,950 MHz is used. A dashed-line range in FIG. 1 may represent free space of the antenna with an operating frequency of 1,950 MHz, and the remaining space within the Smith circle may represent non-free space of the antenna with an operating frequency of 1,950 MHz.

Further, after delivery of a terminal device, impedance of an adapted antenna is determined. For example, an impedance point position of the terminal device is determined to be in free space. When the terminal device performs wireless communication, real-time impedance of an antenna changes with proximity of an object within a specific range, in other words, a position of an actual impedance point within the Smith circle changes, and a changed impedance point position may not match the impedance point position of the adapted antenna, and consequently, a large amount of signal reflection is caused due to the antenna, resulting in reduced radiation efficiency of the antenna. In addition, due to an effect of reflection, a gain of the antenna in a wide band fluctuates. Therefore, antenna impedance needs to be calibrated.

To make a person skilled in the art clearly understand the technical solution provided in embodiments of this application, the following describes an application scenario of the technical solution in this application.

An application scenario of an impedance calibration method is not specifically limited in embodiments of this application. In some possible embodiments, the method in this application may be applied to a wireless communication device. The wireless communication device may include but is not limited to a mobile phone, a tablet computer, a desktop computer, a laptop computer, a notebook computer, an ultra-mobile personal computer (ultra-mobile personal computer, UMPC), a handheld computer, a netbook, a personal digital assistant (personal digital assistant, PDA), a wearable mobile terminal, and a smartwatch.

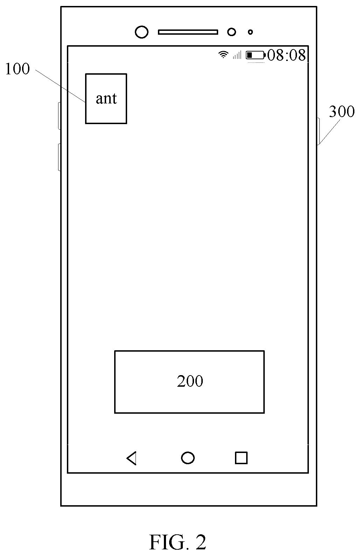

FIG. 2 is a schematic diagram of a wireless communication device according to an embodiment of this application.

As shown in FIG. 2, the mobile phone includes an antenna 110, a battery 200, and a side button 300.

The antenna 110 includes an antenna ant disposed at a frame position of the wireless communication device (such as the mobile phone). The battery 200 is configured to supply power to the mobile phone. The side button 300 is used for receiving a user instruction by the mobile phone. For example, a user may touch and hold the side button 300 to turn the mobile phone on or off.

The following describes an internal architecture of a wireless communication electronic device with reference to the accompanying drawings.

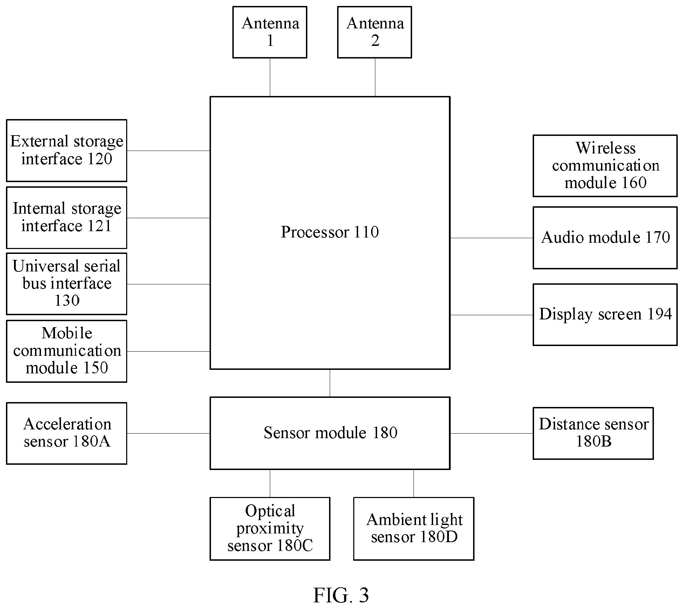

As shown in FIG. 3, the electronic device may include a processor 110, an external memory interface 120, an internal memory 121, a universal serial bus (universal serial bus, USB) interface 130, an antenna 1, an antenna 2, a mobile communication module 150, a wireless communication module 160, an audio module 170, a sensor module 180, a display screen 194, and the like. The sensor module 180 may include an acceleration sensor 180A, a distance sensor 180B, an optical proximity sensor 180C, an ambient light sensor 180D, and the like.

It may be understood that the structure illustrated in this embodiment constitutes no specific limitation on the electronic device. In some other embodiments, the electronic device may include more or fewer components than those shown in the figure, some components may be combined, some components may be split, or a different component deployment may be used. The components in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor (baseband processor, BP), and/or a neural-network processing unit (neural-network processing unit, NPU). Different processing units may be separate components, or may be integrated into one or more processors.

The controller may be a nerve center and a command center of the electronic device. The controller may generate an operation control signal based on instruction operation code and a timing signal, to complete control of instruction fetching and instruction execution.

A memory may be further disposed in the processor 110 and is configured to store instructions and data. In some embodiments, the memory in the processor 110 is a cache. The memory may store instructions or data recently used or cyclically used by the processor 110. If the processor 110 needs to use the instructions or the data again, the processor may directly invoke the instructions or the data from the memory. This avoids repeated accessing and reduces waiting time of the processor 110, thereby improving system efficiency.

In some embodiments, the processor 110 may include one or more interfaces. The interface may include an inter-integrated circuit (inter-integrated circuit, I2C) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

The I2C interface is a bidirectional synchronous serial bus, including a serial data line (serial data line, SDA) and a serial clock line (derail clock line, SCL). In some embodiments, the processor 110 may include a plurality of I2C buses. The processor 110 may be separately coupled to a touch sensor 180K, a charger, a flash, a camera 193, and the like via different I2C bus interfaces. For example, the processor 110 may be coupled to the touch sensor 180K via the I2C interface, so that the processor 110 communicates with the touch sensor 180K via the I2C bus interface to implement a touch function of the electronic device.

The UART interface is a universal serial data bus used for asynchronous communication. The bus may be a bidirectional communication bus. The bus converts to-be-transmitted data between serial communication and parallel communication. In some embodiments, the UART interface is generally configured to connect the processor 110 and the wireless communication module 160. For example, the processor 110 communicates with a Bluetooth module in the wireless communication module 160 via the UART interface, to implement a Bluetooth function. In some embodiments, the audio module 170 may transmit an audio signal to the wireless communication module 160 via the UART interface, to implement a function of music playback by using a Bluetooth headset.

The USB interface 130 is an interface that complies with a USB standard specification, and may be specifically a Mini USB interface, a Micro USB interface, a USB Type C interface, or the like. The USB interface 130 may be configured to be connected to the charger to charge the electronic device, or may be configured to transmit data between the electronic device and a peripheral device. The USB interface may alternatively be configured to be connected to a headset to play audio using the headset. The interface may alternatively be configured to be connected to another electronic device, such as an AR device.

It may be understood that an interface connection relationship between the modules illustrated in this embodiment is merely an example for descriptions, and does not constitute a limitation on the structure of the electronic device. In some other embodiments of this application, the electronic device may alternatively use an interface connection manner different from that in the foregoing embodiment, or use a combination of a plurality of interface connection manners.

A wireless communication function of the electronic device may be implemented by using the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna in the electronic device may be configured to cover one or more communication frequency bands. Different antennas may further be reused to improve antenna utilization. For example, the antenna 1 may be reused as a diversity antenna of a wireless local area network. In some other embodiments, the antennas may be used in combination with a tuning switch.

The mobile communication module 150 may provide a solution applied to the electronic device for wireless communication such as 2G/3G/4G/5G. The mobile communication module 150 may include at least one filter, a switch, a power amplifier, a low noise amplifier (low noise amplifier, LNA), and the like. The mobile communication module 150 may receive an electromagnetic wave via the antenna 1, perform processing such as filtering and amplification on the received electromagnetic wave, and transmit the electromagnetic wave to the modem processor for demodulation. The mobile communication module 150 may further amplify a signal obtained after modulation by the modem processor, and the amplified signal is converted into an electromagnetic wave via the antenna 1 for radiation. In some embodiments, at least some functional modules of the mobile communication module 150 may be disposed in the processor 110. In some embodiments, at least some functional modules of the mobile communication module 150 and at least some modules of the processor 110 may be disposed in a same device.

The modem processor may include a modulator and a demodulator. The modulator is configured to modulate a to-be-sent low-frequency baseband signal into a medium-high frequency signal. The demodulator is configured to demodulate the received electromagnetic wave signal into a low-frequency baseband signal. The demodulator then transmits the demodulated low-frequency baseband signal to the baseband processor for processing. The low-frequency baseband signal is processed by the baseband processor and then transmitted to the application processor. The application processor outputs a sound signal by using an audio device (not limited to a speaker 170A, a phone receiver 170B, and the like), or displays an image or a video by using the display screen 194. In some embodiments, the modem processor may be a separate component. In some other embodiments, the modem processor may be independent of the processor 110 and may be disposed in a same device as the mobile communication module 150 or another functional module.

The wireless communication module 160 may provide a solution applied to the electronic device for wireless communication including a wireless local area network (wireless local area networks, WLAN) (for example, a wireless fidelity (wireless fidelity, Wi-Fi) network), Bluetooth (bluetooth, BT), a global navigation satellite system (global navigation satellite system, GNSS), frequency modulation (frequency modulation, FM), a near field communication (near field communication, NFC) technology, an infrared (infrared, IR) technology, and the like. The wireless communication module 160 may be one or more components integrating at least one communication processing module. The wireless communication module 160 receives an electromagnetic wave via the antenna 2, performs frequency modulation and filtering processing on an electromagnetic wave signal, and sends a processed signal to the processor 110. The wireless communication module 160 may further receive a to-be-transmitted signal from the processor 110, perform frequency modulation and amplification on the to-be-transmitted signal, and convert an amplified signal into an electromagnetic wave for radiation via the antenna 2.

In some embodiments, in the electronic device, the antenna 1 is coupled to the mobile communication module 150, and the antenna 2 is coupled to the wireless communication module 160, so that the electronic device can communicate with a network and another device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, GNSS, WLAN, NFC, FM, an IR technology, and/or the like. The GNSS may include a global positioning system (global positioning system, GPS), a global navigation satellite system (global navigation satellite system, GLONASS), a Beidou navigation satellite system (beidou navigation satellite system, BDS), a quasi-zenith satellite system (quasi-zenith satellite system, QZSS), and/or a satellite based augmentation system (satellite based augmentation systems, SBAS).

The acceleration sensor 180A may detect magnitudes of acceleration of the electronic device in various directions (generally three axes). When the electronic device is static, a magnitude and a direction of gravity may be detected. The acceleration sensor may be further configured to recognize a posture of the electronic device, and is applied to applications such as switchover between landscape and portrait modes and a pedometer.

The distance sensor 180B is configured to measure a distance. The electronic device may measure a distance through infrared or laser. In some embodiments, in a photographing scenario, the electronic device may measure a distance by using the distance sensor 180F, to implement quick focusing.

The optical proximity sensor 180C may include, for example, a light-emitting diode (LED) and a light detector such as a photodiode. The light emitting diode may be an infrared light-emitting diode. The electronic device emits infrared light outward through the light-emitting diode. The electronic device detects infrared reflected light from a nearby object by using the photodiode. When sufficient reflected light is detected, it may be determined that there is an object near the electronic device. When insufficient reflected light is detected, the electronic device may determine that there is no object near the electronic device. The electronic device may detect, by using the optical proximity sensor 180C, that a user holds the electronic device close to the ear for a call, so that a screen can be automatically turned off to save power. The optical proximity sensor 180C may be further configured to automatically unlock and lock the screen in a leather cover mode and a pocket mode.

The ambient light sensor 180D is configured to sense ambient light brightness. The electronic device may adaptively adjust brightness of the display screen based on the sensed ambient light brightness. The ambient light sensor 180D may be further configured to automatically adjust white balance during photographing. The ambient light sensor 180D may further cooperate with the optical proximity sensor 180C to detect whether the electronic device is in a pocket, to prevent an accidental touch.

In addition, an operating system runs on the foregoing components, for example, an iOS operating system developed by Apple, an Android open source operating system developed by Google, and a Windows operating system developed by Microsoft. An application may be installed and run on the operating system.

The operating system of the electronic device may use a layered architecture, an event-driven architecture, a microkernel architecture, a micro service architecture, or a cloud architecture. In embodiments of this application, a software structure of the electronic device is described by using an Android system with a layered architecture as an example.

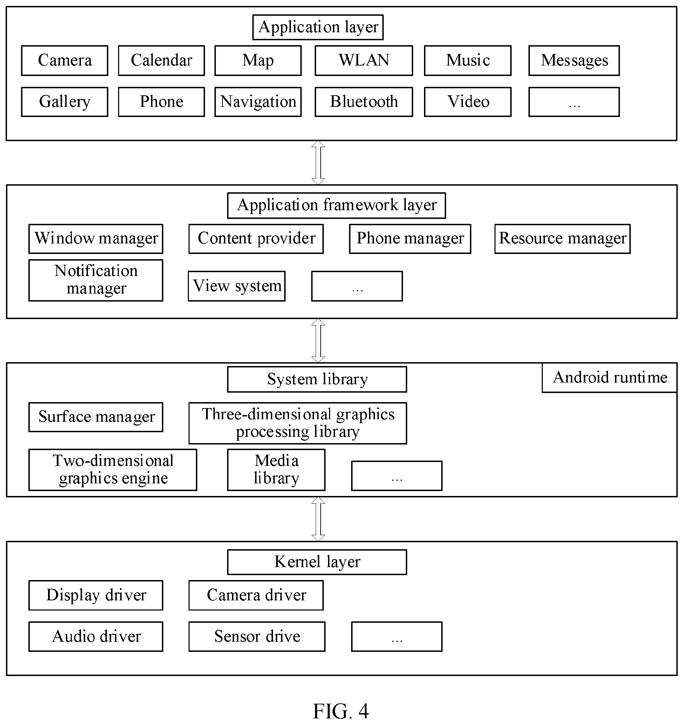

FIG. 4 is a schematic diagram of a software structure of an electronic device according to an embodiment of this application.

In a layered architecture, software is divided into several layers, and each layer has a clear role and task. The layers communicate with each other through software interfaces. In some embodiments, the Android system is divided into four layers that are respectively an application layer, a framework layer, an Android runtime (Android runtime) and a system library, and a kernel layer from top to bottom.

The application layer may include a series of application packages. As shown in FIG. 4, the application packages may include applications such as Camera, Gallery, Calendar, Phone, Map, Navigation, WLAN, Bluetooth, Music, Video, and Messages.

The framework layer provides an application programming interface (application programming interface, API) and a programming framework for an application at the application layer. The framework layer includes some predefined functions. As shown in FIG. 4, the framework layer may include a window manager, a content provider, a view system, a phone manager, a resource manager, a notification manager, and the like.

The window manager is configured to manage a window application. The window manager may obtain a size of a display screen, determine whether there is a status bar, perform screen locking, perform screen capturing, and the like.

The content provider is configured to store and obtain data, and enable the data to be accessible by an application. The data may include a video, an image, an audio, a phone call made and answered, a browsing history, favorites, a phone book, and the like.

The view system includes a visual control, for example, a control for displaying text or a control for displaying a picture. The view system may be configured to create an application. A display interface may include one or more views. For example, a display interface including a message notification icon may include a view for displaying text and a view for displaying a picture.

The phone manager is configured to provide a communication function of the electronic device, for example, call status management (including connected, hang-up, and the like).

The resource manager provides various resources for an application, such as a localized character string, an icon, a picture, a layout file, and a video file.

The notification manager enables an application to display a notification information in a status bar. The notification information may be used for conveying an informative message that may disappear automatically after a short period of time without user interaction. For example, the notification manager is configured to notify download completion, a message prompt, and the like. The notification manager may alternatively provide, on a status bar at the top of the system, a notification in the form of a chart or scroll bar text, for example, a notification of an application running in the background, or provide, on a screen, a notification in the form of a dialog window. For example, text information is prompted in the status bar, a prompt tone is produced, the electronic device vibrates, and an indicator light blinks.

The Android Runtime includes a kernel library and a virtual machine. The Android runtime is responsible for scheduling and managing the Android system.

The kernel library includes two parts. One part is a performance function that the Java language needs to invoke, and the other part is a kernel library of Android.

The application layer and the framework layer run in the virtual machine. The virtual machine executes Java files of the application layer and the framework layer as binary files. The virtual machine is configured to perform functions such as object lifecycle management, stack management, thread management, security and exception management, and garbage collection.

The system library may include a plurality of functional modules, for example, a surface manager (surface manager), a media library (Media Libraries), a three-dimensional graphics processing library (for example, OpenGL ES), a 2D graphics engine (for example, SGL).

The surface manager is configured to manage a display subsystem and provide fusion of 2D and 3D layers for a plurality of applications.

The media library supports playback and recording of a plurality of commonly used audio and video formats, and static image files. The media library may support a plurality of audio and video encoding formats, for example, MPEG4, H.264, MP3, AAC, AMR, JPG, and PNG.

The three-dimensional graphics processing library is configured to implement three-dimensional graphics drawing, image rendering, composition, layer processing, and the like.

The 2D graphics engine is a drawing engine for 2D drawing.

The kernel layer is a layer between hardware and software. The kernel layer includes at least a display driver, a camera driver, an audio driver, and a sensor driver.

It should be noted that although embodiments of this application are explained using the Android system as an example, a basic principle is also applicable to electronic devices based on operating systems such as iOS and Windows.

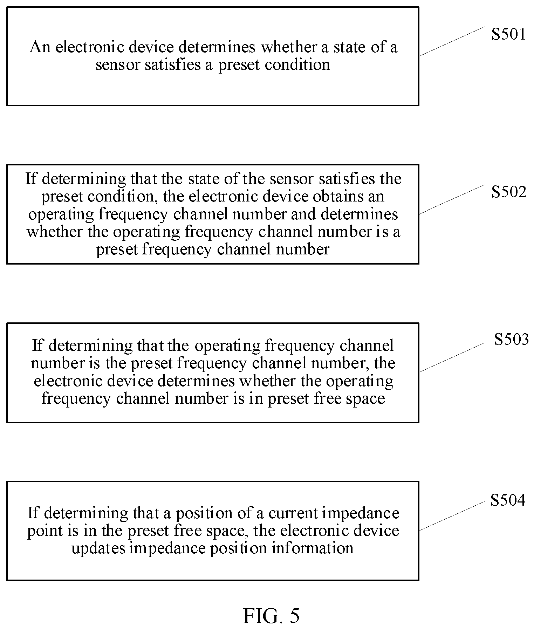

In embodiments of this application, to solve a problem of reduced operating efficiency of an antenna because real-time impedance of the antenna changes with proximity of an object within a specific range and a changed impedance point position may not match an impedance point position of an adapted antenna, this application provides an impedance calibration method, an electronic device, a medium, and a product. In addition, to make the technical solution in this application clear and easy to understand, the impedance calibration method provided in embodiments of this application is described from a perspective of the electronic device with reference to the accompanying drawings. FIG. 5 is a flowchart of an impedance calibration method according to an embodiment of this application. The method includes:

S501: The electronic device determines whether a state of a sensor satisfies a preset condition.

The sensor may include a receiver, an optical proximity sensor, an ambient light sensor, a distance sensor, an A+G sensor, an ultrasonic sensor, and the like. The A+G sensor may also be referred to as an acceleration sensor. The electronic device determining whether the state of the sensor satisfies the preset condition may be determining whether one or more of the following conditions are satisfied.

In a first case, also referred to as a first condition, a scenario of a user using the electronic device is determined based on a state of the receiver. Specifically, a processor 110 may determine whether the receiver receives a communication signal. If a the communication signal is received, it may be determined that the user makes a call by using the electronic device, and in this case, the electronic device is in a call state. If a communication signal is not received, it may be determined that the user does not make a call by using the electronic device, and in this case, the electronic device is in a data service state.

A second case is also referred to as a second condition. The second condition may include two sub-conditions. One sub-condition may be referred to as a first sub-condition, and may be used for determining whether an antenna is blocked by a human body or an object. Specifically, the ambient light sensor 180D may be used to determine whether the antenna is blocked by a human body or an object. The ambient light sensor 180D may sense a light condition around the electronic device, to determine, based on the light condition around the electronic device, whether the antenna of the electronic device is blocked by a human body or an object.

The above only uses the ambient light sensor as an example for description. Certainly, it may alternatively be determined, based on a state of another sensor, whether the antenna is blocked by a human body or an object. For example, the ultrasonic sensor may alternatively be used to determine whether the antenna is blocked by a human body or an object. The ultrasonic sensor may emit a group of highfrequency sound waves. When encountering an object or a human body, the sound waves bounce back and are received by the ultrasonic sensor. Time of the sound waves from emission to return is calculated, and then the time is multiplied by propagation speed of the sound waves in a medium, to obtain a distance between the object or the human body and the ultrasonic sensor, so that it may be determined, based on the distance between the object and the ultrasonic sensor, whether the antenna is blocked by a human body or an object. Certainly, only two sensors, that is, the ambient light sensor 180D and the ultrasonic sensor, are described herein. A person skilled in the art may determine, based on a state of another sensor according to an actual requirement, whether the antenna is blocked by a human body or an object. This is not limited herein.

The other sub-condition may be referred to as a second sub-condition, and may be used for determining whether the electronic device is in a pocket. Specifically, the optical proximity sensor 180C and the ambient light sensor 180D may be used to detect whether the electronic device is in a pocket. It may be determined, based on an ambient light condition detected by the light sensor 180C and the ambient light sensor 180D, whether the electronic device is in the pocket.

A third case is also referred to as a third condition. The third condition may also include two sub-conditions. One sub-condition may be referred to as a third sub-condition, and may be used for determining, based on a state of the sensor, whether the mobile phone is in a portrait mode or a landscape mode. Specifically, it may be determined, based on a state of the acceleration sensor 180A, whether the mobile phone is in a portrait mode or a landscape mode. The other sub-condition may be referred to as a fourth sub-condition, and may be used for determining, based on the state of the acceleration sensor 180A, whether the mobile phone is still placed or handheld.

A fourth case is also referred to as a fourth condition, and may be used for determining, based on the state of the sensor, whether there is an object or a human body approaching the antenna.

Specifically, it may be determined, based on a state of the distance sensor 180B, whether there is an object or a human body approaching around antenna. The distance sensor 180B may emit laser or an infrared ray. When encountering an object or a human body, the laser or the infrared ray bounces back and is received by the distance sensor 180B. The distance sensor 180B determines a distance between the object or the human body and the distance sensor 180B by measuring round-trip time from the laser or the infrared ray to a target, and then determines, based on the distance between the object or the human body and the distance sensor 180B, whether there is the object or the human body approaching the antenna.

Certainly, another method may alternatively be used to determine whether there is an object or a human body approaching the antenna. For example, the optical proximity sensor 180C is used to determine whether there is an object or a human body approaching the antenna. Further, the optical proximity sensor 180C may include, for example, a light-emitting diode (LED) and a light detector such as a photodiode. The light emitting diode may be an infrared light-emitting diode. Further, the electronic device emits infrared light outward through the light-emitting diode. The electronic device detects infrared reflected light from a nearby object by using the photodiode. When sufficient reflected light is detected, it may be determined that there is a human body or an object near the electronic device. When insufficient reflected light is detected, it may be determined that there is no human body or object near the electronic device.

Further, the preset condition may be preset based on a requirement, and may be any condition or any combination of conditions. For example, it may be set that the preset condition is satisfied when it is determined, based on a state of the receiver, that the electronic device is in a data service state and when it is determined, by using the acceleration sensor 180A, that the electronic device is in a portrait mode. It should be noted that an example is merely used for description herein and does not constitute a limitation.

S502: If determining that the state of the sensor satisfies the preset condition, the electronic device obtains an operating frequency channel number and determines whether the operating frequency channel number is a preset frequency channel number.

Positions of a plurality of frequency channel numbers of different operating frequencies may be predetermined within a Smith circle. In other words, a position of a preset frequency channel number is determined. An example in which frequency channel numbers at three operating frequencies are preset is used for description below. For example, the frequency channel numbers at the three operating frequencies are preset, namely, a frequency channel number at an operating frequency of 1,920 MHz, a frequency channel number at an operating frequency of 1,950 MHz, and a frequency channel number at an operating frequency of 1,980 MHz.

Further, a position of an operating frequency channel number of a current antenna, that is, an impedance point position of a current antenna, may be obtained in real time. It may be determined, by comparing the position of the operating frequency channel number of the current antenna with positions of a plurality of preset frequency channel numbers, whether the operating frequency channel number of the current antenna is one of the plurality of preset frequency channel numbers.

Specifically, a threshold distance between each frequency channel number and the operating frequency channel number of the current antenna may be preset. If it is determined that a distance between the operating frequency channel number of the current antenna and the frequency channel number is less than the corresponding threshold distance, it may be determined that the operating frequency channel number of the current antenna is the preset frequency channel number.

In some possible implementations, a frequency channel number closest to the operating frequency channel number of the current antenna may be first determined from the plurality of frequency channel numbers, and then a relationship between the corresponding preset threshold distance and the distance between the frequency channel number and the operating frequency channel number of the current antenna may be determined. If it is determined that the distance between the frequency channel number and the operating frequency channel number of the current antenna is less than or equal to the corresponding preset threshold distance, it may be determined that the operating frequency channel number of the current antenna is the preset frequency channel number. For example, if it is determined that the distance between the frequency channel number and the operating frequency channel number of the current antenna is 7 mm, and the corresponding preset threshold distance is 10 mm, it may be determined that the operating frequency channel number of the current antenna is the preset frequency channel number. If it is determined that the distance between the frequency channel number and the operating frequency channel number of the current antenna is 11 mm, it may be determined that the operating frequency channel number of the current antenna is not the preset frequency channel number.

S503: If determining that the operating frequency channel number is the preset frequency channel number, the electronic device determines whether the operating frequency channel number is in preset free space.

After determining a position of each preset frequency channel numbers within the Smith circle, free space positions corresponding to the preset frequency channel numbers of different operating frequencies may be determined. It should be noted that the free space positions of the frequency channel numbers of different operating frequencies may be different.

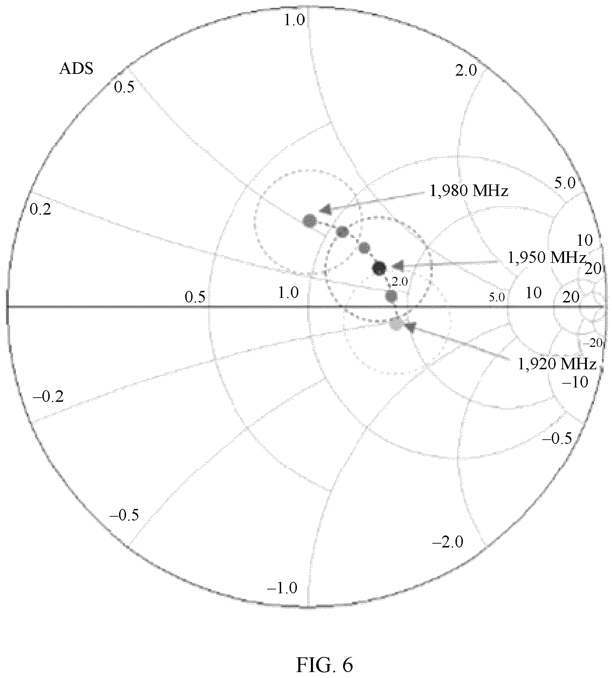

Specifically, free space radiuses corresponding to the frequency channel numbers at different operating frequencies may be preset. In some possible implementations, lengths of the free space radiuses corresponding to the frequency channel numbers at the operating frequencies may be the same, and may be a distance between a human body or an object near the antenna with impedance of 10 mm and the free space. The free space radiuses may alternatively be preset based on a requirement. As shown in FIG. 6, free space of the antenna at three operating frequencies is free space of the antenna at an operating frequency of 1,920 MHz, free space of the antenna at an operating frequency of 1,950 MHz, and free space of the antenna at an operating frequency of 1,980 MHz. For example, a length of the free space radius is preset to be 10 mm. A circle is drawn using a position of a frequency channel number of the operating frequency of 1,980 MHz as a center and 10 mm as a radius, and the circle is the free space corresponding to the frequency channel number at the operating frequency of 1,980 MHz. A circle is drawn using a position of a frequency channel number of the operating frequency of 1,950 MHz as a center and 10 mm as a radius, and the circle is the free space of the antenna at the operating frequency of 1,950 MHz. A circle is drawn using a position of a frequency channel number of the operating frequency of 1,920 MHz as a center and 10 mm as a radius, and the circle is the corresponding free space of the frequency channel number at the operating frequency of 1,920 MHz.

In some possible implementations, the lengths of the free space radiuses corresponding to the frequency channel numbers at the operating frequencies may be different. For example, a length of the free space radius of the frequency channel number of the operating frequency of 1,980 MHz is preset to be 10 mm. A circle is drawn using a position of a frequency channel number of the operating frequency of 1,980 MHz as a center and 10 mm as a radius, and the circle is the free space corresponding to the frequency channel number at the operating frequency of 1,980 MHz. A length of the free space radius of the frequency channel number of the operating frequency of 1,950 MHz is preset to be 8 mm. A circle is drawn with a position of a frequency channel number of the operating frequency of 1,980 MHz as a center and 8 mm as a radius, and the circle is the free space corresponding to the frequency channel number at the operating frequency of 1,950 MHz. Certainly, this are only examples, and are not specifically limited. A person skilled in the art may set the length of the free space radius based on a requirement.

After it is determined that the operating frequency channel number of the current antenna is a preset frequency channel number, it may be further determined whether the operating frequency channel number of the current antenna, that is, the impedance point, is in free space corresponding to the frequency channel number.

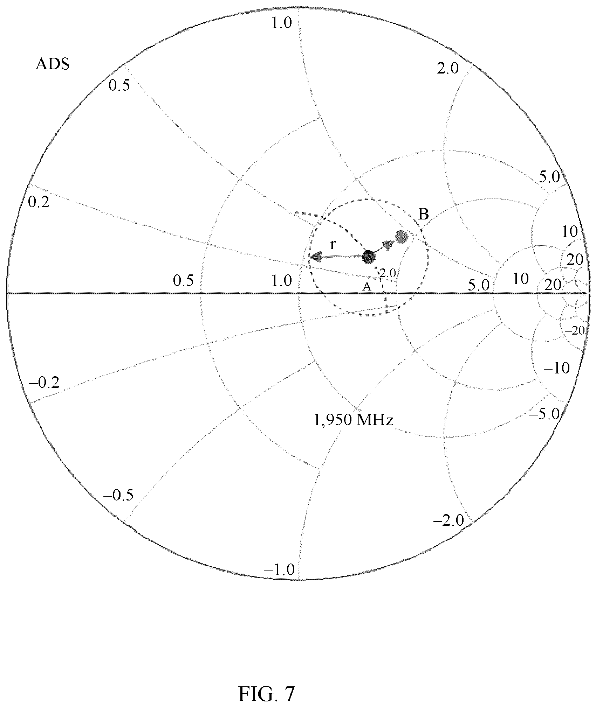

Specifically, whether the distance between the operating frequency channel number of the current antenna and the frequency channel number is less than or equal to a length of the corresponding free space radius may be determined. If it is determined that the distance between the operating frequency channel number of the current antenna and the frequency channel number is less than or equal to the length of the corresponding free space radius, it may be determined that the operating frequency channel number of the current antenna is in the free space. For example, as shown in FIG. 7, if it is determined that the operating frequency channel number of the current antenna is the frequency channel number of the operating frequency of 1,950 MHz and determined that a distance between an operating frequency channel number B of the current antenna and the frequency channel number A of the preset operating frequency of 1,950 MHz is equal to the corresponding free space radius r, it may be determined that the operating frequency channel number of the current antenna, that is, the current impedance point position is in free space corresponding to the frequency channel number A of the operating frequency of 1,950 MHz.

S504: If determining that the current impedance point position is in the preset free space, the electronic device updates impedance position information.

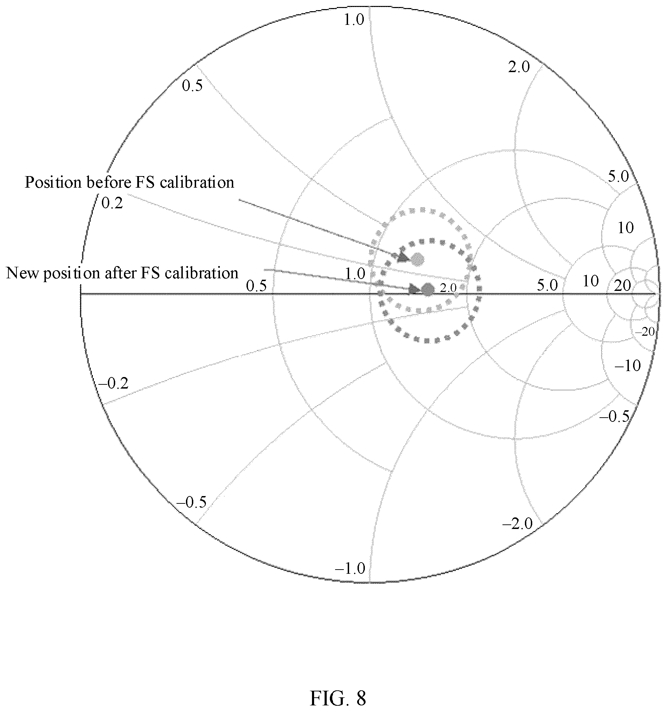

After determining that the current impedance point position is in the preset free space, the electronic device may determine that an antenna of the electronic device is in a free space scenario, and may update the impedance position information of the antenna. As shown in FIG. 8, an example in which the current impedance point position in the free space corresponding to the preset operating frequency of 1,950 MHz is used for description. The impedance point position of the antenna may be updated to a position of an operating frequency channel number of the current antenna at the operating frequency of 1,950 MHz, and the free space radius r may remain unchanged, to further determine an updated impedance point position and free space corresponding to an updated impedance point and use the updated impedance point position as a position of reference impedance, so as to calibrate antenna impedance.

In this embodiment of this application, the electronic device may first determine whether the state of the sensor satisfies the preset condition. If it is determined that the state of the sensor satisfies the preset condition, the electronic device may obtain the operating frequency channel number and determine whether the operating frequency channel number is the preset frequency channel number. If determining that the operating frequency channel number is the preset frequency channel number, the electronic device determines whether the operating frequency channel number is in the preset free space. If determining that the operating frequency channel number, that is, the current impedance point position is in the preset free space, the electronic device may update the impedance position information. In this way, it may be determined whether the antenna of the electronic device is in the free space scenario by determining whether the state of the sensor satisfies the preset condition and determining whether the operating frequency channel number is in the preset free space. When it is determined that the antenna of the electronic device is in the free space scenario, the impedance point position of the current antenna may be used as the position, so that the position of the reference impedance in the free space scenario may be updated to calibrate antenna impedance.

An embodiment of this application further provides a computer storage medium including computer instructions. When the computer instructions are run on a mobile terminal, an electronic device is enabled to perform the method according to any one of the foregoing embodiment.

An embodiment of this application further provides a computer program product including instructions. When the instructions are run by an electronic device, the electronic device is enabled to perform the method according to any one of the foregoing embodiment.

The technical solution of embodiments of this application essentially, or the part contributing to conventional technologies, or all or part of the technical solution may be implemented in the form of a software product. The computer software product is stored in a storage medium and includes several instructions for instructing a computer device (which may be a personal computer, a server, a network device, or the like) or a processor to perform all or some of steps of the method described in embodiments. The storage medium includes any medium that can store program code, such as a flash memory, a removable hard disk, a read-only memory, a random access memory, a magnetic disk, or an optical disc.

## Claims

1. An impedance calibration method, applied to an electronic device, wherein the method comprises:
determining a state of a sensor in the electronic device;
obtaining an impedance point position of a current antenna, in a smith chart, in response to the state of the sensor satisfying a preset condition; and
using the impedance point position of the current antenna as a position of reference impedance when it is determined that the impedance point position of the current antenna is in preset free space to calibrate impedance,
wherein before the determining a state of a sensor in the electronic device, the method further comprises:
determining, in a smith chart, positions of a plurality of preset frequency channel numbers of different operating frequencies and a free space radius corresponding to each preset frequency channel number; and
determining, in the smith chart, based on a position of a preset frequency channel number of each operating frequency and a corresponding free space radius, free space of each preset frequency channel number at a corresponding operating frequency.

2. The method according to claim 1, wherein the using the impedance point position of the current antenna as a position of reference impedance when it is determined that the impedance point position of the current antenna is located in preset free space comprises:
determining, when it is determined that a distance between an impedance point of the current antenna and a corresponding preset frequency channel number is less than or equal to a free space radius corresponding to the preset frequency channel number, that an impedance point position of the current antenna is in the preset free space corresponding to the preset frequency channel number; and
using the impedance point position of the current antenna as the position of the reference impedance when it is determined that the impedance point position of the current antenna is in the preset free space.

3. The method according to any one of claims 1 or 2, wherein after the using the impedance point position of the current antenna as the position of the reference impedance, the method further comprises:
determining a free space position of the impedance point of the current antenna based on the impedance point position of the current antenna and the free space radius of the corresponding preset frequency channel number.

4. The method according to any one of claims 1 to 3, wherein the using the impedance point position of the current antenna as a position of reference impedance if it is determined that the impedance point position of the current antenna is located in preset free space comprises:
using the impedance point position of the current antenna as the position of the reference impedance if it is determined that the impedance point of the current antenna is a preset frequency channel number and that the impedance position of the current antenna is in free space corresponding to the preset frequency channel number.

5. The method according to claim 4, wherein the method further comprises:
separately determining a distance between the impedance point of the current antenna and each preset frequency channel number;
comparing each distance with a corresponding preset threshold distance; and
the using the impedance point position of the current antenna as the position of the reference impedance when it is determined that the impedance point of the current antenna is a preset frequency channel number and that the impedance position of the current antenna is in free space corresponding to the preset frequency channel number comprises:
determining, when it is determined that the distance is less than or equal to the corresponding preset threshold distance, that the impedance point of the current antenna is the corresponding preset frequency channel number; and
using the impedance point position of the current antenna as the position of the reference impedance when it is determined that the impedance point of the current antenna is the preset frequency channel number and that the impedance position of the current antenna is in the free space corresponding to the preset frequency channel number.

6. The method according to any one of claims 1 to 5, wherein the sensor comprises: at least one of a receiver, an ambient light sensor, a distance sensor, an acceleration sensor, an ultrasonic sensor, and an optical proximity sensor.

7. An electronic device, comprising: a processor and a memory, wherein
the memory stores one or more computer programs, the one or more computer programs comprise instructions, and when the instructions are executed by the processor, the electronic device is enabled to perform the method according to any one of claims 1 to 6.

8. A computer storage medium, comprising computer instructions, wherein when the computer instructions are run on an electronic device, the electronic device is enabled to perform the method according to any one of claims 1 to 6.

9. A computer program product, wherein when the computer program product runs on a computer, the computer performs the method according to any one of claims 1 to 6.

## Patentansprüche

1. Impedanzkalibrierungsverfahren, das auf ein elektronisches Gerät angewendet wird, wobei das Verfahren umfasst:
Bestimmen eines Zustands eines Sensors in dem elektronischen Gerät;
Ermitteln einer Impedanzpunktposition einer aktuellen Antenne in einem Smith-Diagramm als Reaktion darauf, dass der Zustand des Sensors eine voreingestellte Bedingung erfüllt; und
Verwenden der Impedanzpunktposition der aktuellen Antenne als Referenzimpedanzposition, wenn bestimmt wird, dass sich die Impedanzpunktposition der aktuellen Antenne in einem voreingestellten freien Raum befindet, um die Impedanz zu kalibrieren,
wobei das Verfahren vor dem Bestimmen eines Zustands eines Sensors in dem elektronischen Gerät ferner umfasst:
Bestimmen von Positionen einer Vielzahl von voreingestellten Frequenzkanalnummern unterschiedlicher Betriebsfrequenzen und eines jedem voreingestellten Frequenzkanal zugeordneten Freiraumradius in einem Smith-Diagramm; und
Bestimmen des freien Raums jeder voreingestellten Frequenzkanalnummer bei einer entsprechenden Betriebsfrequenz im Smith-Diagramm basierend auf einer Position einer voreingestellten Frequenzkanalnummer jeder Betriebsfrequenz und einem entsprechenden Freiraumradius.

2. Verfahren nach Anspruch 1, wobei das Verwenden der Impedanzpunktposition der aktuellen Antenne als eine Position der Referenzimpedanz, wenn bestimmt wird, dass sich die Impedanzpunktposition der aktuellen Antenne in einem voreingestellten freien Raum befindet, umfasst:
Bestimmen, wenn festgestellt wird, dass ein Abstand zwischen einem Impedanzpunkt der aktuellen Antenne und einer entsprechenden voreingestellten Frequenzkanalnummer kleiner oder gleich einem der voreingestellten Frequenzkanalnummer entsprechenden Freiraumradius ist, dass sich eine Impedanzpunktposition der aktuellen Antenne in dem der voreingestellten Frequenzkanalnummer entsprechenden voreingestellten freien Raum befindet; und
Verwenden der Impedanzpunktposition der aktuellen Antenne als die Position der Referenzimpedanz, wenn bestimmt wird, dass sich die Impedanzpunktposition der aktuellen Antenne in dem voreingestellten freien Raum befindet.

3. Verfahren nach einem der Ansprüche 1 oder 2, wobei nach dem Verwenden der Impedanzpunktposition der aktuellen Antenne als die Position der Referenzimpedanz das Verfahren ferner umfasst:
Bestimmen einer Freiraumposition des Impedanzpunkts der aktuellen Antenne basierend auf der Impedanzpunktposition der aktuellen Antenne und dem Freiraumradius der entsprechenden voreingestellten Frequenzkanalnummer.

4. Verfahren nach einem der Ansprüche 1 bis 3, wobei das Verwenden der Impedanzpunktposition der aktuellen Antenne als Referenzimpedanzposition, wenn bestimmt wird, dass die Impedanzpunktposition der aktuellen Antenne in einem voreingestellten freien Raum liegt, umfasst:
Verwenden der Impedanzpunktposition der aktuellen Antenne als Position der Referenzimpedanz, wenn bestimmt wird, dass der Impedanzpunkt der aktuellen Antenne eine voreingestellte Frequenzkanalnummer ist und dass die Impedanzposition der aktuellen Antenne in einem der voreingestellten Frequenzkanalnummer entsprechenden freien Raum liegt.

5. Verfahren nach Anspruch 4, wobei das Verfahren ferner umfasst:
separates Bestimmen eines Abstands zwischen dem Impedanzpunkt der aktuellen Antenne und jeder voreingestellten Frequenzkanalnummer;
Vergleichen jedes Abstands mit einem entsprechenden voreingestellten Schwellenabstand; und
das Verwenden der Impedanzpunktposition der aktuellen Antenne als Position der Referenzimpedanz, wenn bestimmt wird, dass der Impedanzpunkt der aktuellen Antenne eine voreingestellte Frequenzkanalnummer ist und dass die Impedanzposition der aktuellen Antenne in einem der voreingestellten Frequenzkanalnummer entsprechenden freien Raum liegt, umfasst:
Bestimmen, wenn bestimmt wird, dass der Abstand kleiner oder gleich dem entsprechenden voreingestellten Schwellenabstand ist, dass der Impedanzpunkt der aktuellen Antenne die entsprechende voreingestellte Frequenzkanalnummer ist; und
Verwenden der Impedanzpunktposition der aktuellen Antenne als Position der Referenzimpedanz, wenn bestimmt wird, dass der Impedanzpunkt der aktuellen Antenne die voreingestellte Frequenzkanalnummer ist und dass die Impedanzposition der aktuellen Antenne in dem der voreingestellten Frequenzkanalnummer entsprechenden freien Raum liegt.

6. Verfahren nach einem der Ansprüche 1 bis 5, wobei der Sensor umfasst: mindestens einen aus einem Empfänger, einem Umgebungslichtsensor, einem Abstandssensor, einem Beschleunigungssensor, einem Ultraschallsensor und einem optischen Näherungssensor.

7. Elektronische Vorrichtung, umfassend: einen Prozessor und einen Speicher, wobei
der Speicher ein oder mehrere Computerprogramme speichert, die ein oder mehrere Computerprogramme Anweisungen umfassen, und wenn die Anweisungen durch den Prozessor ausgeführt werden, die elektronische Vorrichtung dazu befähigt wird, das Verfahren nach einem der Ansprüche 1 bis 6 durchzuführen.

8. Computerspeichermedium, umfassend Computeranweisungen, wobei, wenn die Computeranweisungen auf einer elektronischen Vorrichtung ausgeführt werden, die elektronische Vorrichtung dazu befähigt wird, das Verfahren nach einem der Ansprüche 1 bis 6 durchzuführen.

9. Ein Computerprogrammprodukt, wobei der Computer, wenn das Computerprogrammprodukt auf einem Computer ausgeführt wird, das Verfahren nach einem der Ansprüche 1 bis 6 durchführt.

## Revendications

1. Procédé d'étalonnage d'impédance, appliqué à un dispositif électronique, dans lequel le procédé comprend :
la détermination d'un état d'un capteur dans le dispositif électronique ;
l'obtention d'une position de point d'impédance d'une antenne actuelle, dans un abaque de Smith, en réponse à l'état du capteur satisfaisant une condition prédéfinie ; et
l'utilisation de la position du point d'impédance de l'antenne actuelle comme position d'impédance de référence lorsqu'il est déterminé que la position du point d'impédance de l'antenne actuelle est dans un espace libre prédéfini pour étalonner l'impédance,
dans lequel avant la détermination d'un état d'un capteur dans le dispositif électronique, le procédé comprend en outre :
la détermination, dans un abaque de Smith, de positions d'une pluralité de numéros de canaux de fréquence prédéfinis de différentes fréquences de fonctionnement et d'un rayon d'espace libre correspondant à chaque numéro de canal de fréquence prédéfini ; et
la détermination, dans l'abaque de Smith, sur la base d'une position d'un numéro de canal de fréquence prédéfini de chaque fréquence de fonctionnement et d'un rayon d'espace libre correspondant, de l'espace libre de chaque numéro de canal de fréquence prédéfini à une fréquence de fonctionnement correspondante.

2. Procédé selon la revendication 1, dans lequel l'utilisation de la position du point d'impédance de l'antenne actuelle comme position d'impédance de référence lorsqu'il est déterminé que la position du point d'impédance de l'antenne actuelle est située dans un espace libre prédéfini comprend :
la détermination, lorsqu'il est déterminé qu'une distance entre un point d'impédance de l'antenne actuelle et un numéro de canal de fréquence prédéfini correspondant est inférieure ou égale à un rayon d'espace libre correspondant au numéro de canal de fréquence prédéfini, qu'une position de point d'impédance de l'antenne actuelle est dans l'espace libre prédéfini correspondant au numéro de canal de fréquence prédéfini ; et
l'utilisation de la position du point d'impédance de l'antenne actuelle comme position de l'impédance de référence lorsqu'il est déterminé que la position du point d'impédance de l'antenne actuelle est dans l'espace libre prédéfini.

3. Procédé selon l'une quelconque des revendications 1 ou 2, dans lequel après l'utilisation de la position du point d'impédance de l'antenne actuelle comme position de l'impédance de référence, le procédé comprend en outre :
la détermination d'une position d'espace libre du point d'impédance de l'antenne actuelle sur la base de la position du point d'impédance de l'antenne actuelle et du rayon d'espace libre du numéro de canal de fréquence prédéfini correspondant.

4. Procédé selon l'une quelconque des revendications 1 à 3, dans lequel l'utilisation de la position du point d'impédance de l'antenne actuelle comme position d'impédance de référence s'il est déterminé que la position du point d'impédance de l'antenne actuelle est située dans un espace libre prédéfini comprend :
l'utilisation de la position du point d'impédance de l'antenne actuelle comme position de l'impédance de référence s'il est déterminé que le point d'impédance de l'antenne actuelle est un numéro de canal de fréquence prédéfini et que la position d'impédance de l'antenne actuelle se trouve dans l'espace libre correspondant au numéro de canal de fréquence prédéfini.

5. Procédé selon la revendication 4, dans lequel le procédé comprend en outre :
la détermination séparée d'une distance entre le point d'impédance de l'antenne actuelle et chaque numéro de canal de fréquence prédéfini ;
la comparaison de chaque distance avec une distance seuil prédéfinie correspondante ; et
l'utilisation de la position du point d'impédance de l'antenne actuelle comme position de l'impédance de référence lorsqu'il est déterminé que le point d'impédance de l'antenne actuelle est un numéro de canal de fréquence prédéfini et que la position d'impédance de l'antenne actuelle se trouve dans l'espace libre correspondant au numéro de canal de fréquence prédéfini comprend :
la détermination, lorsqu'il est déterminé que la distance est inférieure ou égale à la distance seuil prédéfinie correspondante, que le point d'impédance de l'antenne actuelle est le numéro de canal de fréquence prédéfini correspondant ; et
l'utilisation de la position du point d'impédance de l'antenne actuelle comme position de l'impédance de référence lorsqu'il est déterminé que le point d'impédance de l'antenne actuelle est le numéro de canal de fréquence prédéfini et que la position d'impédance de l'antenne actuelle se trouve dans l'espace libre correspondant au numéro de canal de fréquence prédéfini.

6. Procédé selon l'une quelconque des revendications 1 à 5, dans lequel le capteur comprend : au moins l'un parmi un récepteur, un capteur de lumière ambiante, un capteur de distance, un capteur d'accélération, un capteur à ultrasons et un capteur de proximité optique.

7. Dispositif électronique, comprenant : un processeur et une mémoire, dans lequel
la mémoire stocke un ou plusieurs programmes informatiques, le ou les programmes informatiques comprennent des instructions, et lorsque les instructions sont exécutées par le processeur, le dispositif électronique est activé pour mettre en œuvre le procédé selon l'une quelconque des revendications 1 à 6.

8. Support de stockage informatique, comprenant des instructions informatiques, dans lequel lorsque les instructions informatiques sont exécutées sur un dispositif électronique, le dispositif électronique est activé pour mettre en œuvre le procédé selon l'une quelconque des revendications 1 à 6.

9. Produit-programme d'ordinateur, dans lequel, lorsque le produit-programme d'ordinateur s'exécute sur un ordinateur, l'ordinateur met en œuvre le procédé selon l'une quelconque des revendications 1 à 6.
